(19) Europäisches Patentamt
European Patent Office
Office européen des brevets

(11) **EP 2 573 579 A2**

(12) **EUROPÄISCHE PATENTANMELDUNG**

(43) Veröffentlichungstag:
**27.03.2013 Patentblatt 2013/13**

(51) Int Cl.:
***G01R 31/36*** *(2006.01)*

(21) Anmeldenummer: **12176232.2**

(22) Anmeldetag: **12.07.2012**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **21.09.2011 DE 102011113828**

(71) Anmelder: **Techem Energy Services GmbH**
**65760 Eschborn (DE)**

(72) Erfinder:
• **Heisser, Lothar**
**55299 Nackenheim (DE)**
• **Klee, Helmut**
**61118 Bad Vilbel (DE)**
• **Reus, Jürgen**
**63579 Freigericht (DE)**

(74) Vertreter: **KEIL & SCHAAFHAUSEN**
**Patentanwälte**
**Cronstettenstraße 66**
**60322 Frankfurt am Main (DE)**

(54) **Verfahren zur Ermittlung des Batterieladezustands einer Batterie in einem batteriebetriebenen Gerät und Verbrauchserfassungsgerät**

(57) Die Erfindung betrifft ein Verfahren zur Ermittlung des Batterieladezustands einer Batterie (2) in einem batteriebetriebenen Gerät (1) mit zeitlich wechselndem Stromverbrauch, bei dem die Spannung ($U_L$ der Batterie (2) gemessen und daraus ein Kriterium für den Batterieladezustand abgeleitet wird. Es ist vorgesehen, dass die Spannung ($U_L$) der Batterie (2) in mindestens zwei verschiedenen Lastzuständen (A) oder einem ausgewählten charakteristischen Lastzustand (A) gemessen wird. Ferner wird ein zur Durchführung des vorbeschriebenen Verfahrens eingerichtetes Verbrauchserfassungsgerät beschrieben.

Fig. 2

EP 2 573 579 A2

## Beschreibung

Die Erfindung betrifft ein Verfahren zur Ermittlung des Batteriezustands einer Batterie in einem batteriebetriebenen Gerät, insbesondere einem Verbrauchserfassungsgerät, und ein solches batteriebetriebenes Verbrauchserfassungsgerät. Das Verbrauchserfassungsgerät kann insbesondere ein Heizkostenverteiler, ein Wasserzähler und besonders bevorzugt ein Datensammler sein, welcher ihm von einem Verbrauchsmessgerät zugesandte Daten an eine zentrale Sammelstelle, bspw. einen Masterdatensammler, weiterleitet. Während der Energiebedarf der Verbrauchsmessgeräte, welche ihre Daten per Funk in vorgegebenen Zeitabständen an den Datensammler aussenden, häufig noch relativ gut vorhersagbar ist, kann der Energiebedarf eines Datensammlers nur schwer vorhergesagt werden, da dieser im Rahmen der Funkübertragung maßgeblich von der Menge der an ihn übermittelten und weiterzuleitenden Daten abhängt. Die Erfindung betrifft also insbesondere ein batteriebetriebenes Geräte mit zeitlich wechselndem, insbesondere gepulstem Stromverbrauch, wie er insbesondere bei einer Funkübertragung von Daten beim Senden und/oder Empfangen auftreten kann. Auch können unterschiedliche Rechenleistungen eines in dem Gerät enthaltenen Mikroprozessors zu einem zeitlich wechselnden Stromverbrauch führen. Bei dem Verfahren zur Ermittlung des Batterieladezustands der Batterie wird die Spannung der Batterie gemessen und daraus ein Kriterium für den Batterieladezustand abgeleitet.

Elektronische batteriebetriebene Geräte werden üblicherweise durch einen Mikrocomputer, insbesondere in Form eines Mikroprozessors, gesteuert, der in Kenntnis des Entladegrads der Batterie in geeigneter Weise agieren kann. Bei einer bevorstehenden Entladung der Batterie kann durch ein in dem Mikroprozessor des Geräts implementiertes Computerprogramm bspw. der Funktionsumfang des Gerätes durch Verzicht auf weniger wichtige Funktionen eingeschränkt werden, um eine längere Betriebsdauer des Gesamtgeräts mit den wichtigen Funktionen zu erreichen. Außerdem kann, wenn die Entladung soweit fortgeschritten ist, dass eine kritische Spannung bspw. zum Betrieb des Mikroprozessors nicht mehr aufrecht erhalten werden kann, das Gerät kontrolliert ausgeschaltet werden, bevor das System bspw. einen unkontrollierten Systemabsturz erleidet, der zusätzlich zu einem Tausch der Batterie ggf. auch noch einen umfangreichen Wartungseinsatz bzw. Tausch des Gerätes erforderlich macht.

Unter Batterien im Sinne dieser Anmeldung werden sowohl Primärzellen als auch Akkumulatoren verstanden. Eine Primärzelle ist eine galvanische Zelle, die nach der Entladung nicht wiederaufgeladen werden kann. Sie wird heute meist als Trockenbatterie ausgeführt, wobei verschiedenen Typen entsprechend den eingesetzten Materialen bezeichnet werden. Hierzu zählen insbesondere Alkali-Mangan-Batterien, Zink-Kohle-Batterien, Nickel-Oxyhydroxid-Batterien, Lithium-Batterien, Lithium-Eisensulfid-Batterien, Lithium-Thionylchlorid-Batterien, Zink-Luft-Batterien, Zinkchlorid-Batterien, Quecksilberoxid-Zink-Batterien, Silberoxid-Zink-Batterien und/oder Natrium-Nickelchlorid-Batterien. Akkumulatoren können nach einer Entladung wiederaufgeladen werden, um erneut Ladung abzugeben. Besonders bevorzugt kann das erfindungsgemäße Verfahren bei Lithium-Ionen-Akkumulatoren, Nickelmetallhydrid-Akkumulatoren (NiMH) oder Nickelkadmium-Akkumulatoren (NiCd) eingesetzt werden.

Im Rahmen der Verbrauchswerterfassung kommt es neben den eigentlichen Verbrauchsmessgeräten, welche relevante Verbrauchsdaten messen und bspw. in einer unidirektionalen Funkverbindung an einen oder mehrere Datensammler aussenden, auch zu dem typischen Anwendungsfall der Datensammler, welche die Verbrauchsdaten von den Verbrauchserfassungsgeräten, insbesondere Heizkostenverteilern und Wasserzählern, empfangen und weiterleiten. Aufgabe dieser Datensammler kann es auch sein, Prozessdaten zur verbrauchsabhängigen Korrektur bestimmter Regelprozesse, bspw. von Heizungskennlinien im Rahmen einer wärmeleistungsadaptiven Vorlauftemperaturregelung, aufzuarbeiten und/oder weiterzuleiten. Auch auf derartige Geräte bezieht sich die Erfindung besonders bevorzugt.

Ein bekanntes Verfahren zur Ermittlung des Entladegrades einer Batterie ist eine Spannungsmessung, bei der durch dauernde oder zeitlich getastete Messungen pulsförmiger Stromverbraucher mit wechselnden Pulsgrößen bspw. von durch Mikroprozessoren gesteuerte Geräte bei Unterschreiten einer festen Spannungsschwelle eine Entladung der Batterie signalisiert und/oder die Funktionalität des Gerätes eingeschränkt bzw. eingestellt.

Aus der EP 1 308 738 B1 ist ferner ein Verfahren bekannt, bei dem der Ladezustand des Akkumulators durch Integration der bei Ladung und Entladung fließenden Strommengen ermittelt wird.

Eine Kombination beider Verfahren ist aus der US 6,127,806 bekannt, bei der durch Messung einer Ruhespannung und Vergleich mit Ruhespannungskennlinien der Ladezustandswert ermittelt wird und eine Integration nur ausnahmsweise dann stattfindet, wenn die Ruhespannung einer Zelle größer als diejenige Spannung ist, die für einen Ladezustandswert von 100 % festgelegt worden ist.

Diese Messungen sind jedoch ungenau, weil die Spannung an den Klemmen von Batterien im Allgemeinen von der aktuellen Stromlast, aber auch von der Historie der Stromlast abhängt. Bei anderen Batterietypen, bspw. Lithium-Thionylchlorid-Batterien (Li-SOCl$_2$) bleibt die Ruhespannung, welche durch die Zellspannung der elektrochemischen Spannungsreihe bestimmt ist, während der Entladung nahezu konstant. Jedoch bricht unter Stromlast die Spannung bisweilen stark zusammen, so dass die Aussage einer Ruhespannungsmessung zu ungenau ist. Dieser Effekt wird Passivierung genannt.

Insgesamt ist bei Batterien die verfügbare Kapazität sehr stark vom Einsatzfall und von den Geräteeigenschaften, d.h. dem Lastprofil (Strom über Zeit), den Umgebungsbedingungen (Temperatur), den Bauteiltoleranzen und den Batterieeigenschaften (Selbstentladung) abhängig. Insbesondere bei nicht deterministischen Kommunikationshäufigkeiten, wie sie gerade auch in hierarchischen Funknetzen auftreten, in denen Verbrauchsdaten über Datensammler an eine zentrale Stelle weitergeleitet werden, ist der verfügbare Energieinhalt individuell von jedem Gerät und dessen Position im Funknetz abhängig. Außerdem unterliegen die Herstellungsprozesse von Batterien Streuungen bezüglich der Kapazität des Individualexemplars.

In diesen Fällen kann von den Batterien die individuell verfügbare Kapazität nicht optimal ausgenutzt werden, wenn die Ermittlung des Batterieladezustands ungenau ist. Ziel muss es nämlich sein, auch bei stromintensiven Funktionen bei teilentladener Batterie noch sicher zu stellen, dass das Gerät immer noch mit seiner minimal benötigten Batteriespannung versorgt wird und nicht in einen undefinierten Zustand gerät, der einen Software- oder Hardware-Reset auslöst.

Aufgabe der vorliegenden Erfindung ist also, in batteriebetriebenen elektronischen (und insbesondere mikrocomputergesteuerten) Geräten mit wechselndem zeitlichen Stromverbrauch den aktuellen Batterieladezustand zu ermitteln und die Betriebsspannung der Batterie zu überwachen, damit das Gerät in geeigneter Weise bspw. durch Einschränken der Funktion, Melden des Entladegrades durch Datenübertragen und/oder Signalisierung eines notwendigen Batteriewechsels reagieren kann.

Diese Aufgabe wird erfindungsgemäß mit den Merkmalen des Verfahrens gemäß Anspruch 1 sowie mit einem zur Durchführung des Verfahrens eingerichteten Verbrauchserfassungsgerät entsprechend Anspruch 14 gelöst.

Dazu ist erfindungsgemäß insbesondere vorgesehen, dass die Spannung der Batterie in mindestens zwei verschiedenen Lastzuständen oder einem ausgewählten charakteristischen Lastzustand (A) gemessen wird.

Hierdurch ist es möglich, das Verhalten der Batterie bei unterschiedlichen Lastsituationen zu berücksichtigen, wie sie durch verschiedene Aktionen des Gerätes, bspw. dem Verarbeiten von Daten in dem Mikroprozessor oder dem Aussenden oder Empfangen von Daten, auftreten. Durch das Messen der durch die Batterie zur Verfügung gestellten Spannung, vorzugsweise an den Batterieanschlüssen des Gerätes, ist es möglich, den individuell verfügbaren Energieinhalt der Batterie im jeweiligen Einsatzfall mit den individuellen Geräteeigenschaften so weit wie möglich auszunutzen, um Wartungseinsätze für einen Batterietausch zu minimieren und dennoch einen zuverlässigen Betrieb des batteriebetriebenen Geräts zu ermöglichen. Dies ist bspw. in einem hierarchisch gegliederten Funknetz unabdingbar, da bei einem Ausfall eines zentralen, in einer ranghöheren Hierarchieebene angeordneten Datensammlers eine Vielzahl von Daten nicht an die zentrale Sammelstelle nicht weitergeleitet würde. Besonders bevorzugt ist es, wenn verschiedene Lastsituationen ausgesucht werden, bei denen die größten Spannungseinbrüche der Batterie aufgrund der Lastsituation zu erwarten sind. Andererseits ist es auch möglich, die Spannung der Batterie in nur einem Lastzustand zu messen, der jedoch speziell ausgewählt ist und bei dem es sich um einen charakteristischen Lastzustand handelt. Bei einem charakteristischen Lastzustand handelt es sich erfindungsgemäß um einen Lastzustand mit einem definierten Spannungswert, der auch für den im ordnungsgemäßen Betrieb minimal auftretenden Spannungswert charakteristisch ist, bspw. weil der Abstand des in diesem Lastfall gemessenen Spannungswert zu dem minimal auftretenden Spannungswert bekannt ist oder als bekannt abgeschätzt ist. Einfacher Weise kann zur Messung natürlich auch der identifizierbare Lastfall ausgewählt werden, bei dem üblicher Weise die größte Belastung der Energie auftritt. So wird automatisch die Minimalspannung erfasst und die vorbeschriebene Umrechnung über den bekannten Abstand zur Minimalspannung kann entfallen. Diese Lösung bietet sich insbesondere für Systeme an, die bspw. über Jahre hinweg für bestimmte Anwendungen genutzt werden und ein immer wiederkehrendes Anwendungsprofil aufweisen. Dann kann durch die Auswahl eines charakteristischen Lastzustands für die Messung des Anwendungsprofils eine sehr genaue Ermittlung des Batterieladezustands erfolgen. Beide der zuvor beschriebenen Varianten eignen sich auch besonders für eine Vorhersage, wann der Batterieladezustand des Geräts bzw. eines Systems aus mehreren entsprechend eingerichteten Geräten einen ordnungsgemäßen Betrieb nicht mehr sicherstellt, um vor einem Ausfall des Geräts und/oder Systems einen Wartungseinsatz, bspw. zur Beschränkung der Gerätefunktionen und/oder zu einem Batterietausch, herbeizuführen.

Ein wesentlicher Vorteil des erfindungsgemäßen Verfahrens liegt darin, dass aufgrund dieser Informationen ein Standard-Wechselintervall für Batterien anhand aller in einem Funknetz beteiligten Geräte, bspw. aller zur Weiterleitung eingesetzten Datensammler, festgelegt und/oder verändert werden kann, ohne dass eine Entnahme von Batterien zur genauen Analyse und Ermittlung der Restkapazität erforderlich wäre. Das Wechselintervall kann somit jeweils abhängig von einer individuellen Anlage festgelegt werden. Dies ist von besonderem Vorteil, da je nach Funksituation in einem Gebäude sich gerade bei der Verbrauchswerterfassung unterschiedliche Lebenszyklen der Gesamtanlage aufgrund der zur Verfügung stehenden Batteriekapazität ergeben. Gleichzeitig wird die Gefahr eines Ausfalls des Funksystems wegen leerer Batterien einzelner Verbrauchserfassungsgeräte, insbesondere einzelner Datensammler, minimiert, da insbesondere auch gerätespezifische Parameter, wie die den Stromverbrauch maßgeblich bestimmende Sendeleistung der Geräte, automatisch berücksichtigt werden können.

Gemäß einer bevorzugten einfachen Ausführungsform der vorliegenden Erfindung wird der Minimalwert der gemessenen Spannungen, d.h. von mehreren und insbesondere zu unterschiedlichen Zeiten bei zumindest teilweise verschiedenen Lastsituationen gemessenen Spannungen, ermittelt und mit einem vorgegebenen Schwellwert verglichen. Dabei werden die gemessenen Spannungen vorzugsweise jeweils in vorgegebenen Zeitintervallen zusammengefasst ausgewertet, innerhalb derer jeweils das Minimum für dieses Zeitintervall (z.B. ein Tag) bestimmt wird. Ein geeigneter absoluter Schwellwert kann die minimal zulässige Betriebsspannung sein, mit der die in dem batteriebetriebenen Gerät enthaltenen elektronischen Bauteile, insbesondere der Mikroprozessor und/oder Sender- und/oder Empfängerbaustein, betrieben werden müssen. Vorzugsweise können auch gestaffelte Schwellwerte vorgegeben werden, um je nach Erreichen eines Schwellwertes unterschiedliche Aktionen auszulösen. Dies ermöglicht es, bereits frühzeitig zu reagieren und die verbleibende Batterieladung gezielt zu nutzen.

Da der gemessene Spannungswert teilweise auch stark von der in dem Gerät zum Zeitpunkt der Messung herrschenden Temperatur abhängt, kann gemäß einer erfindungsgemäßen Weiterentwicklung vorgeschlagen werden, auch die bei einer gemessen Spannung herrschende Temperatur des Geräts zu erfassen, bspw. durch Ermittlung mittels eines in dem Gerät vorhandenen Temperatursensors oder einfacher Weise mittels des Mikroprozessors, der zum Erfassen seiner Betriebstemperatur eingerichtet ist. Auf diese Weise ist es möglich, die Werte der gemessenen Spannung auf eine in dem Gerät üblicherweise herrschenden Temperatur zu normieren bzw. entsprechende Korrekturen anzubringen. Hintergrund dieser Maßnahme ist, dass der Stromverbrauch eines Mikrocomputers oder -prozessors einschließlich dessen Peripherie (bspw. Messschaltungs- und/oder Hochfrequenz-Schaltungsteile) im Allgemeinen von der Umgebungstemperastur abhängig ist. Gleiches gilt auch für die minimal erforderliche Betriebsspannung elektronischer Schaltungsteile, die daher erfindungsgemäß auch durch temperaturabhängige Schwellwerte zum Vergleich mit dem Minimalwert der gemessenen Spannung überwacht werden kann. Darüber hinaus sind auch die Passivierungseigenschaften und der Innenwiderstand einer Batterie abhängig von der Umgebungstemperatur. Der Kapazitätswert und der Innenwiderstand eines in erfindungsgemäßen Geräten häufig auch verwendeten Pufferkondensators sind ebenfalls abhängig von der Umgebungstemperatur. In der Regel steigt der Innenwiderstand von Pufferkondensatoren und Batterien bei niedrigen Temperaturen. Deshalb ist es nützlich die Umgebungstemperatur zu messen, um die bei der jeweiligen Temperatur gemessenen Daten richtig interpretieren und/oder Schwellwerte temperaturabhängig festlegen zu können. Insoweit kann auch eine im Labor gemessene typische Umgebungstemperaturabhängigkeit der o.a. Parameter verwendet werden, um im Betrieb der Geräte zur Ermittlung des Batterieladezustands auf die Eigenschaften bei einer anderen Umgebungstemperatur rückschließen zu können. Eine andere Möglichkeit zur Verwendung der erfassten Temperaturwerte ist die vorzugsweise exponentielle oder lineare dynamische Exploration der Messwerte auf andere Umgebungstemperaturen.

Um die historische Entwicklung des Spannungsverlaufs der Batterie zu erhalten und die jeweiligen Umstände der Messung festzuhalten, wird gemäß einer besonders bevorzugten Ausführungsform vorgeschlagen, dass der Wert der gemessenen Spannung, der Anlass des Lastzustandes (bspw. als eine Lastzustands-Identifikation für immer wieder auftretende Aktionen des Gerätes oder als Laststromwert oder als Messwerte, aus den der Laststromwert ermittelt werden kann) und/oder der Zeitpunkt der Messung gespeichert werden. Ergänzend können ggf. die bei der gemessenen Spannung herrschende Temperatur und/oder weitere anlagespezifischer Daten in einem Datensatz erfasst und gespeichert werden. Die anlagenspezifischen Daten können insbesondere die Anzahl der Geräte im Funknetz, die räumliche Anordnung des Gerätes im Funknetz, bspw. die Hierarchieebene des Gerätes im Funknetz, der Gebäudetyp oder ähnliches sein. Sofern die vorbeschriebene Methode des Findens des Minimums des Werts der gemessenen Spannung angewendet wird, ist es möglich, die diesem Minimalwert zugeordneten vorerwähnten Werte in einem Datensatz mit abzuspeichern und die übrigen Werte, welche nicht im Zusammenhang mit diesem erfassten Minimalwert stehen, zu verwerfen.

Der kritischste Wert ist das Minimum der gemessenen Spannung (d.h. des-Spannungsmesswertes), welcher auch als Minimalwert bezeichnet wird, in dem jeweiligen vorgegebenen Zeitintervall, da dieser den geringsten Abstand zu der minimal erforderlichen Betriebsspannung bzw. zu der Hardware-Resetschwelle der Schaltung hat. Insoweit kann erfindungsgemäß für ein vorgegebenes Zeitintervall auch nur ein einziger Datensatz, nämlich der zum Minimalwert der gemessenen Spannung (d.h. dem minimalen Spannungsmesswert) gehörige abgespeichert werden. Falls während des vorgegebenen Zeitintervalls der aktuelle Spannungswert den bisher gespeicherten Minimalwert der gemessenen Spannung unterschreitet, ersetzt der zu dem aktuellen Spannungswert gehörende aktuelle Datensatz den gespeicherten Datensatz. Ferner können die gespeicherten Werte historisch abgelegt werden, sowohl für das aktuelle Zeitintervall als auch vorangegangene Zeitintervalle. Dies kann bspw. in dem Gerät (etwa dem Verbrauchserfassungsgerät oder Datensammler) oder in einer Zentrale (etwa einem zentraler Datensammler oder einer entfernten Zentrale) erfolgen, in welche die Datensätze übertragen werden.

In einer zusätzlichen oder alternativen Variante des erfindungsgemäßen Verfahrens wird vorgeschlagen, dass aus je mindestens zwei Werten der gemessenen Spannung mit unterschiedlicher Last der Innenwiderstand der Batterie ermittelt wird und der Verlauf des Innenwiderstands über die Zeit, d.h. für zeitlich unmittelbar oder mittelbar aufeinander folgende Werte der gemessenen Spannung, ausgewertet wird. Bei fehlender Passivierung der Batterie, worauf später noch eingegangen werden wird, ist der Innenwiderstand der Batterie über die Zeit konstant, solange in der Batterie noch ein ausreichender Energievorrat vorhanden ist. Dies gilt typischerweise bis zu einem Entladungsgrad zwischen 60 % und 80 %. Dann fängt der Innenwiderstand mit weiterer Entladung der Batterie an zu steigen, wobei sich die Steigung des Innenwiderstands mit weitergehender Entladung immer mehr vergrößert. Der Innenwiderstand ist eine Rechengröße, die aus der internen Zellspannung der Batterie und dem im Lastfall fließenden Strom die auch als Spannung bezeichnete Betriebsspannung der Batterie berechnet.

Durch Auswertung des Verlaufs des Innenwiderstands über die Zeit, d.h. abgeleitet aus den einzelnen Messungen der Spannung der Batterie, kann somit ein Frühindikator zur Verfügung gestellt werden, der auf eine bevorstehende Entladung hindeutet, wobei je nach ermittelter Steigung auf verschiedene Entladungsfälle der Batterie rückgeschlossen werden kann. Hierdurch ist es möglich, abhängig von einer fortschreitenden Entladung unterschiedliche Aktionen, wie Warnmeldungen, Funktionseinschränkungen bis hin zum Abschalten des Geräts, durchzuführen. Dazu können die ermittelten Steigungswerte bspw. mit einem Schwellwert für die Steigung verglichen werden.

Bei Geräten, die zum Abdecken von Lastspitzem mit besonders hohem Strombedarf einen Pufferkondensator zum Zwischenspeichern und Abrufen einer bestimmten Ladungsmenge, wie sie bspw. bei einer Funkaussendung von Daten benötigt wird, kann erfindungsgemäß vorgesehen sein, den Spannungsverlauf in einem Lastfall, bei welchem der Pufferkondensator vorzugsweise zumindest teilweise, bspw. um bis zu 10% bis 20% oder ggf. bis zu (maximal) 18%, entladen wird, durch drei Messungen der Spannung der Batterie zu drei verschiedenen Zeitpunkten $t_1$, $t_2$, $t_3$ zu messen. Eine erste Messung zum Zeitpunkt $t_1$ erfolgt vorzugsweise unmittelbar vor Beginn des Lastfalls (A), die zweite Messung zum Zeitpunkt $t_2$ vorzugsweise unmittelbar vor Ende des Lastfalls (A) und die dritte Messung eine vordefinierte Zeit $t_3$ nach Ende des Lastfalls (A), vorzugsweise während der Ladungsphase des Pufferkondensators, bspw. wenn dieser zwischen 85% bis 95%, ggf. ca. 87%, geladen ist. Diese vordefinierte Zeit $t_3$ hängt insbesondere von dem erwarteten Innenwiderstand und der Kondensatorgröße ab und kann auch dynamisch in Abhängigkeit dieser Größen eingestellt werden. Es ist vorteilhaft, die Zeit $t_3$ als Differenz zu der Zeit $t_2$ festzulegen, da die Zeit $t_2$ in etwa das Ende des Lastfalls anzeigt, wie vorstehend erläutert. Es ist auch möglich, die Zeit $t_3$ (relativ zur Zeit $t_2$) bei Erreichen eines bestimmten Spannungswertes, bspw. bei 75% der Spannungsdifferenz (U2-U1), zu messen.

Die Zeiten $t_1$ und $t_2$ sollen erfindungsgemäß vorzugsweise unmittelbar vor bestimmten Ereignissen, nämlich dem Beginn und dem Ende des Lastfalls liegen. Damit ist erfindungsgemäß gemeint, dass die Messung t1 zu einem Zeitpunkt stattfindet, der gerade so weit vor dem Beginn des Lastfalls liegt, dass die Spannungsmessung abgeschlossen ist, bevor der Lastfall beginnt. Vorzugsweise sollen zwischen dem Ende der Spannungsmessung und dem Beginn des Lastfalls keine anderen Lastfälle in dem Gerät mehr eintreten. Eine sinnvolle Zeitspanne, welche der Messzeitpunkt $t_1$ vor dem Beginn des Lastfalls liegt, ist daher durch die Messzeit für die Spannungsmessung (typischer Weise in der Größenordnung von 10 ms) und eine zusätzliche Sicherheitszeit definiert, die durch den Fachmann geeignet gewählt werden kann und üblicherweise die Größenordnung der Messzeit nicht überschreitet, vorzugsweise etwa maximal die Hälfte der Messzeit beträgt. In gleicher Weise liegt der Messzeitpunkt $t_2$ eine sinnvolle Zeitspanne vor Ende des Lastfalls, welche durch die Messzeit für die Spannungsmessung und eine zusätzliche Sicherheitszeit definiert. Die angegebene Größenordnung gilt in derselben Weise. Da die Lastfälle insbesondere in dem bevorzugten Anwendungsfall der Verbrauchserfassungssysteme in den Geräten durch den integrierten Mikroprozessor gesteuert werden, sind der Beginn und das Ende der Lastfälle in dem Gerät bekannt, sodass die Messungen zu den Zeiten $t_1$ und $t_2$ durch den Mikroprozessor geeignet initiiert werden können.

Mit der vorbeschriebenen Messung ist es möglich, bei bekanntem Laststrom auf die Kapazität des Pufferkondensators bzw. bei bekannter Kapazität des Pufferkondensators auf den Laststrom zu schließen. Dies kann ausgenutzt werden, um zunächst bei einem Lastfall mit bekanntem Strom die Kapazität des Pufferkondensators zu ermitteln und diese ermittelte Kapazität dann zu verwenden, verschiedene Lastfälle zu erfassen und zu bestimmen.

Gemäß einer besonders bevorzugten Ausführungsform der vorgeschlagenen Erfindung ist vorgesehen, dass bspw. vor einer Messung der Spannung der Batterie und/oder in vordefinierten, festen oder ggf. dynamisch anpassbaren Zeitintervallen eine Überprüfung der Passivierung der Batterie durch Messen der Spannung der Batterie in einem Strompuls erfolgt, wobei ein erster Passivierungs-Spannungswert unmittelbar nach dem Beginn des Strompulses und ein zweiter Passivierungs-Spannungswert unmittelbar vor dem Ende des Strompulses gemessen wird und aus jeder Messung, d.h. sowohl aus dem ersten als auch dem zweiten Passivierungs-Spannungswert, der Innenwiderstand bestimmt wird. Unterschiedliche Werte für diesen Innenwiderstand aus den beiden Messungen zeigen eine Passivierung an.

Die Passivierung entsteht, wenn der mittlere Strom im Gerät, bezogen auf die Elektrodenfläche, über längere Zeit kleiner als ein bestimmter Wert, bspw. etwa 2 $\mu$A/cm$^2$, ist. Die Passivierung kann durch einen Verbrauch mit einem ausreichend hohem Stromfluss zurückgeführt bzw. aufgebrochen werden, in einem Verbrauchserfassungsgerät bspw. durch einen über einen gewissen Zeitraum aufrecht erhaltenen Sendebetrieb oder eine hohe Rechenleistung des Mikroprozessors mit entsprechend hohem Stromverbrauch. Als Maßnahme kann auch vorgesehen sein, den mittleren Stromverbrauch auf einen Wert zu erhöhen , bei dem die vorgenannte Passivierung nicht auftritt, und/oder Stromverbrauchsaktionen häufiger oder zeitlich gleichmäßiger verteilt auszuführen. Hierzu kann bspw. eine geschickte Verteilung der Aufgaben in einem bzw. in mehreren Geräten erfolgen, die zu einer zeitlich gleichmäßigeren Auslastung der Geräte und damit einer gleichmäßigeren Stromentnahme führt. Außerdem ist es möglich, zusätzliche Stromverbräuche durch eine Aktivierung von Verbrauchern zu erreichen, auch wenn diese in dem eigentlich durchgeführten Prozess gar nicht notwendig sind. Diese Variante ist allerdings nur sinnvoll möglich, wenn die Gesamtkapazität der Batterie die Erhöhung des mittleren Stromverbrauchs auf einen die Passivierung vermeidenden Wert erlaubt, ohne dass die gewünschten Lebensdauern unterschritten werden. In einer einfachen Ausführungsform kann dazu die Summe aller Strompulse innerhalb eines Zeitintervalls integriert und ggf. zusätzliche Strom verbraucht werden, um im Mittel eines Zeitintervalls von z.B. einem Tag auf mehr als 2 $\mu$A/cm$^2$ Elektrodenfläche zu kommen. Eine andere Ausführungsform der Erfindung teilt bei Erkennen einer ansteigenden Passivierung die zu übertragenden, für das System nicht zeitkritischen Datenblöcke und Betriebsaktionen so auf, dass durch diese Aufteilung eine gleichmäßigere, mittlere Last entsteht, die das weitere Ansteigen der Passivierung verhindert bzw. minimiert und/oder eine bestehende Passivierung aufbricht oder rückführt. Da der kalkulatorische mittlere Stromverbrauch eines erfindungsgemäßen Gerätes in der Verbrauchswerterfassung, insbesondere eines Datensammlers oder Verbrauchserfassungsgeräte, höher liegt als der Mindestverbrauch, bei dem eine Passivierung auftritt, kann in der Regel durch gleichmäßige Lastaufteilung eine Passivierung vollständig verhindert werden. Diese Einflussnahme auf das Lastmanagement des Gerätes, die insbesondere als Datenverarbeitungsprogramm in dem Mikroprozessor des Geräts implementiert sein kann, muss jedoch nur vorgenommen werden, wenn ein Ansteigen der Passivierung erkannt wird.

Andernfalls kann erfindungsgemäß vorgesehen sein, dass bei bzw. nach einer festgestellten Passivierung durch Anschalten eines Verbrauchers mit vorgewählter Stromstärke über einen vorgewählten Zeitraum die Passivierung der Batterie rückgeführt wird. Dies ist in der Regel mit einem geringeren Verbrauch an Batteriekapazität verbunden als eine dauernde Erhöhung des mittleren Stromverbrauchs.

Nach dem Aufbrechen der Passivierungsschicht kann ggf. durch eine erneute Bestimmung der Passivierung der Passivierungszustand der Batterie überprüft werden, um festzustellen, ob die Passivierung tatsächlich rückgeführt wurde.

Die Stromstärke und/oder die Zeitdauer beim Einschalten des Verbrauchers können erfindungsgemäß abhängig von dem Grad der festgestellten Passivierung, d.h. insbesondere der Differenz der Passivierungs-Spannungswerte festgelegt werden, bspw. durch eine Wertetabelle, einen funktionalen Zusammenhang oder dergleichen. Ein einfacher funktionaler Zusammenhang kann bspw. eine proportionale oder durch eine andere geeignete Funktion gegebene Abhängigkeit sein.

Im Rahmen des erfindungsgemäß vorgeschlagenen Verfahrens kann zusätzlich oder als Messung in dem Lastzustand "Grundlast", d.h. ohne Last, auch die Ruhespannung der Batterie gemessen werden, die sich dann ergibt, wenn außer den die Grundfunktionen des Gerätes sicherstellenden Verbrauchern in ihrer Basisfunktion keine weiteren Verbraucher des Gerätes aktiv sind. Hierdurch ist eine zusätzliche Überwachung der Ruhespannung möglich. Außerdem ist es dann möglich, den Absolutwert des Innenwiderstands aus einer Messung der Batteriespannung unter bekannter Last, d.h. mit einem bekannten Strom, zu bestimmen.

Gemäß einer bevorzugten Weiterentwicklung des vorgeschlagenen Verfahrens zur Ermittlung des Batterieladezustands kann vorgesehen sein, dass eine Vorhersage der Lebensdauer der Batterie auf der Grundlage der gemessenen Spannungen durchgeführt wird, wobei ggf. die zusätzlich bei der Spannungsmessung erhobenen Daten, wie bspw. Temperatur oder dergleichen, mit verwendet werden können. Hierdurch ist eine konkrete Prognose der Batterielebensdauer im individuellen Gerät möglich.

Gemäß einer dazu vorgeschlagenen Ausführungsform kann durch Interpolation der über die Zeit ermittelten Minimalwerte der Spannung ein Trend der Minimalwerte der Spannung der Batterie abgeleitet und der erwartete Zeitpunkt festgestellt werden, wann der Minimalwert der Spannung aufgrund des Trends einen vorgegebenen Schwellwert unterschreiten wird. Die Interpolation kann bspw. durch eine Anpassung (mathematischer Fit) einer geeigneten Funktion, bspw. einer Polynomfunktion, an die über die Zeit ermittelten Minimalwerte der Spannung erfolgen, so dass eine Voraussage in die Zukunft möglich ist.

Zusätzlich oder alternativ ist auch möglich, die Spannung der Batterie zu verschiedenen Zeitpunkten bei gleicher Last zu messen und einen Trend der Spannung der Batterie für den Fall abzuleiten, dass sich die zukünftige Last bzw. Lastverteilung der Batterie nicht ändert. Hierbei kann der für die Auswertung herangezogene Zeitabschnitt an den Zeitpunkt der Messung angepasst werden. So ist es bspw. möglich, alle Messpunkte innerhalb eines Strompulses zu legen. Dann ist eine kurzfristige Voraussage möglich, wie lange ein solcher Strompulse mit dieser konstanten Last bei der aktuellen Batterieladung möglich ist, um bspw. einen vorgegebenen Schwellwert nicht zu unterschreiten. Dies kann im Hinblick auf eine erlaubte Sendeleistung oder die Länge von Funktelegrammen, die ggf. je nach zur Verfügung stehender Batteriekapazität angepasst werden kann, sinnvoll sein.

Bei längeren Zeitabständen der Messpunkte ist es möglich, auch langfristig eine Vorhersage für eine immer wiederkehrende pulsartige Last zu machen, die bspw. durch eine Lastzustands-Identifikation identifizierbar ist. In diesem Fall ist unter Last die im zeitlichen Mittel über einen signifikanten Zeitbraum, bspw. einen Ablese- und Erfassungszyklus in der Verbrauchswerterfassung bis hin zu dem bisherigen Lebenszyklus der Batterie, gemittelte Last in ihrer typischen zeitlichen Teilung über verschiedene Lastpulse (Strompulse) gemeint. Indem die Messungen jeweils bei gleicher aktueller Last stattfinden, wird eine Vorhersage möglich, wann für diesen speziellen Lastfall, bspw. mit dieser Lastzustands-Identifikation, bei insgesamt gleichbleibender mittlerer Gesamtlast über die Zeit für die gesamte Batterie die Spannung nicht mehr ausreicht, d.h. unter einen vorgegebenen Schwellwert sinkt.

Ferner ist es möglich, aus jeder Messung der Spannung der Batterie die interne Zellspannung der Batterie und einen Trend der Zellspannung der Batterie abzuleiten. Dies ermöglicht eine genauere Vorhersage, wann die Batterie tatsächlich entladen sein wird. Bei bekannten Strom- und Innenwiderstand kann diese Zellspannung der Batterie einfach berechnet werden. Wie bereits beschrieben kann mit dem Ruhespannungsverlauf und dem Innenwiderstandsverlauf eine Aussage zu jedem Lastfall getroffen werden. Damit kann also vorhergesagt werden, bei welcher Last die minimal zur Verfügung zu stellende Gerätespannung unterschritten würde.

Ferner betrifft die Erfindung ein batteriebetriebenes Verbrauchserfassungsgerät, insbesondere einen Heizkostenverteiler, Wasserzähler und besonders bevorzugt einen Datensammler ggf. mit Zusatzfunktionen (wie einen Masterdatensammler zur Organisation des Netzwerks und/oder ein Modul zur wärmebedarfsadaptiven Vorlauftemperaturregelung einer Heizungsanlage), mit einem Mikroprozessor und einem Funksender und/oder Funkempfänger zur drahtlosen Datenübertragung von Erfassungswerten, wobei der Mikroprozessor über Messeingänge zur Messung der Spannung der Batterie verfügt. Der Mikroprozessor des Verbrauchserfassungsgeräts ist erfindungsgemäß zur Durchführung des vorbeschriebenen Verfahrens oder Teilen hiervon eingerichtet. Für eine ggf. vorgesehene Temperaturmessung kann ein eigener oder ein in dem Mikroprozessor integrierter Temperatursensor vorgesehen sein.

Weitere Vorteile, Merkmale und Anwendungsmöglichkeiten der vorliegenden Erfindung ergeben sich auch aus der nachfolgenden Beschreibung von Ausführungsbeispielen und der Zeichnung. Dabei bilden alle beschrieben und/oder bildlich dargestellten Merkmale für sich oder in beliebiger Kombination den Gegenstand der vorliegenden Erfindung, auch unabhängig von ihrer Zusammenfassung in den Ansprüchen oder deren Rückbezügen.

Es zeigen:

Fig. 1     schematisch eine Ausführungsform eines erfindungsgemäßen, batteriebetriebenen Verbrauchserfassungsgeräts, mit dem die erfindungsgemäße Ermittlung des Batterieladezustands durchgeführt werden kann;

Fig. 2     ein Spannungs-Strom-Diagramm der Batterie eines erfindungsgemäßen Verbrauchserfassungsgeräts im Betrieb über die Zeit in einer schematischen Darstellung;

Fig. 3     den zeitlichen Verlauf der Spannung der Batterie eines erfindungsgemäßen Verbrauchserfassungsgeräts im Betrieb bei einem kontinuierlichen niedrigen Stromverbrauch und einem gepulsten hohen Stromverbrauch sowie den zugehörigen Innenwiderstand in Abhängigkeit von der Entladung der Batterie;

Fig. 4     den zeitlichen Verlauf der Spannung der Batterie eines erfindungsgemäßen Verbrauchserfassungsgeräts im Zustand einer Passivierung bei Anlegen eines Strompulses über die Zeit;

Fig. 5     den historischen Verlauf der Minimalwerte der gemessenen Spannungen der Batterie eines erfindungsgemäßen Verbrauchserfassungsgeräts gemäß als Funktion von Zeitintervallen, welche der Minimumbildung zugrunde lagen, mit einer Inter- und Extrapolation;

Fig. 6     den historischen Verlauf der gemessenen Spannungen der Batterie eines erfindungsgemäßen Verbrauchserfassungsgeräts als Funktion von Messzeitpunkten über die Zeit für verschiedene Lastfälle mit einer Inter- und Extrapolation;

Fig. 7     schematisch eine weitere Ausführungsform eines erfindungsgemäßen, batteriebetriebenen Verbrauchserfassungsgeräts, mit dem die erfindungsgemäße Ermittlung des Batterieladezustands durchgeführt werden kann und

Fig. 8     den zeitlichen Verlauf der Spannung eines erfindungsgemäßen, batteriebetriebenen Verbrauchserfassungsgeräts mit einem Pufferkondensators während eines Spannungspulses.

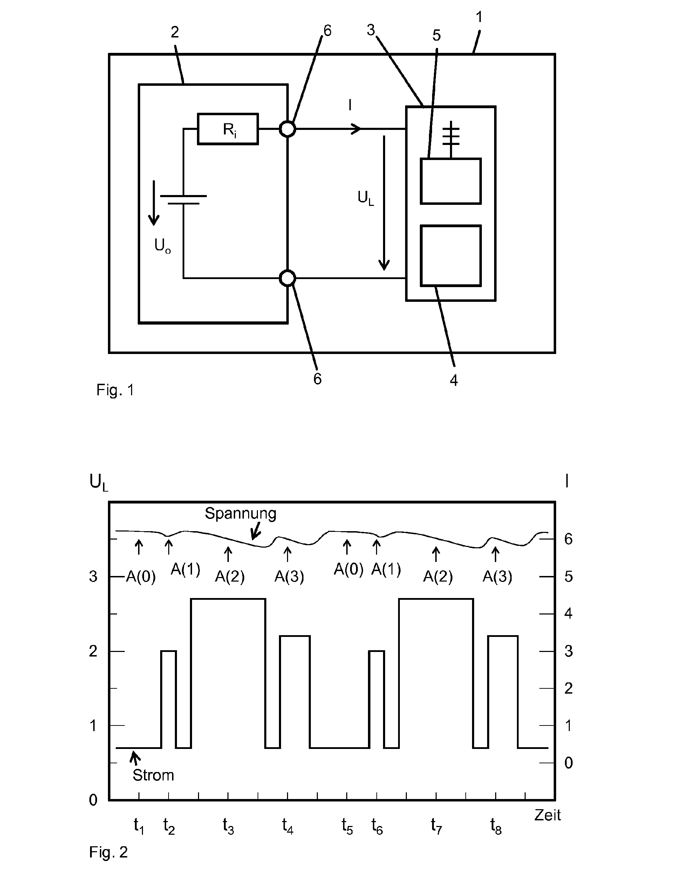

Fig. 1 stellt schematisch ein bspw. als Datensammler ausgebildetes Verbrauchserfassungsgerät 1 mit einer Batterie 2 dar, an welche als Verbraucher 3 ein Mikroprozessor 4 und eine Sende- und Empfangseinrichtung 5 angeschlossen sind. Der Mikroprozessor 4, die Sende- und Empfangseinrichtung 5 sowie ggf. weitere nicht dargestellte Verbraucher in dem Verbrauchserfassungsgerät 1 werden durch die Batterie 2 mit Energie versorgt.

Dazu liegt an den Klemmen 6 der Batterie 2 die durch die Batterie 2 zur Verfügung gestellte und messbare Spannung $U_L$ an, die auch als Last- bzw. Betriebsspannung bezeichnet wird. Ein Verbraucher 3 zieht während seines Betriebs den Strom I aus der Batterie 2, der zwischen den Klemmen 6 fließt.

In einem Ersatzschaltbild, welches die Eigenschaften der Batterie 2 beschreibt, kommt die Spannung $U_L$ der Batterie durch die sog. Zell- bzw. Ruhespannung $U_0$ und den Innenwiderstand $R_i$ zustande.

Die Ruhespannung $U_0$ wird durch das elektrochemische System, d.h. die Zellspannung durch die elektrochemische Spannungsreihe, ohne Last durch Verbraucher 3 und nur bei Grundlast der Geräte zur Verfügung gestellt und ist im Allgemeinen abhängig von dem Entladegrad der Batterie 2, der Umgebungstemperatur und der Historie der Last der Batterie 2. Der Innenwiderstand $R_i$ hängt typischerweise auch von dem Entladegrad der Batterie, der Umgebungstemperatur und der zeitlichen Historie der Last ab. Ferner ist der Innenwiderstand $R_i$ auch noch von dem Wert des aktuell durch den Verbraucher 3 gezogenen Stroms I abhängig. Der Verbraucher 3 kann z.B. ein Widerstand, eine Stromsenke oder eine Spannungssenke sein.

Als elektronische Bauteile in einem Verbrauchserfassungsgerät kommen neben dem bereits beschriebenen Mikroprozessor 4 und der Sende- und/oder Empfangseinrichtung 5 auch Messgeräte zum Erfassen der Verbrauchswerte und/oder von Temperaturen sowie eine Anzeige oder weitere elektronische Einheiten in Frage.

Fig. 2 zeigt schematisch den korrelierten Strom-Spannungsverlauf eines Verbrauchserfassungsgeräts 1 über die Zeit, wobei die Spannung $U_L$ zu verschiedenen Zeitpunkten $t_i$ gemessen wird. Die in dem Verbrauchserfassungsgerät 1 vorhandenen Verbraucher 3 benötigen für die von ihnen zu bewältigenden Aufgaben zeitweise mehr oder weniger Strom I, wobei auch für die Grundversorgung der Verbraucher 3 ein gewisser Grundstrombedarf herrscht. Dies zeigt sich daran, dass der Strom I auch zu einem Zeitpunkt $t_1$, zu dem keiner der Verbraucher 3 besondere Aktivitäten entfaltet, nicht null ist, sondern einen kleinen endlichen Wert aufweist. Dies ist in Fig. 2 zu den Zeiten $t_1$ und $t_5$ besonders deutlich zu erkennen, zu denen die Grundspannung $U_{L=0}$ der Batterie 2 gemessen wird. Der Zeitpunkt dieser Messung ist mit dem Lastzustands-Identifikator A(0) gekennzeichnet. Zu der Zeit $t_2$ und $t_6$ wird für eine vergleichsweise kurze Zeit durch einen Verbraucher 3 ein gewisser Strom benötigt. Dies zeigt sich in einem ersten Typ Strompuls zu den Zeitpunkten $t_2$ und $t_6$. Der Anlass wird durch den Lastzustands-Identifikator A(1) gekennzeichnet. In einem Verbrauchserfassungsgerät könnte eine derartige Last bspw. durch eine bestimmte Bearbeitungsprozedur von Daten in dem Mikroprozessor 4 hervorgerufen werden.

Zu den Zeitpunkten $t_3$ und $t_7$ wird über einen längeren Zeitraum ein vergleichsweise hoher Strom benötigt, relativ zu den Strompulsen zu den Zeitpunkten $t_2$ und $t_6$). Der zugehörige Lastzustands-Identifikator ist mit A(2) bezeichnet. In einem Verbrauchserfassungsgerät 1, bspw. einem Datensammler, kann eine derartige Last bspw. beim Aussenden von Daten durch die Sende- und Empfangseinrichtung 5 entstehen.

Zu den nachfolgenden Zeitpunkten $t_4$ bzw. $t_8$ wird eine im Vergleich sowohl im Hinblick auf die Amplitude als auch auf die Dauer des Strompulses mittlerer Strompuls benötigt, der den Lastzustand-Identifikator A(3) erhält. Dieser kann bspw. beim Empfangen von Daten durch einen Datensammler entstehen.

Es wird darauf hingewiesen, dass Fig. 2 lediglich schematisch verschiedene Lastzustände (einschließlich der Grundlast L=0) zeigt, ohne dass die in beliebigen Einheiten angegebenen Amplituden noch die dargestellten Lastfälle in ihrer relativen zeitlichen Anordnung, Amplitude oder Dauer einem realen Fall entsprechen müssen. Die Darstellung der Fig. 2 dient lediglich einer Erläuterung des grundsätzlichen Verhaltens der Batterie 2 in einem Verbrauchserfassungsgerät 1 während des Betriebs.

Zu den Zeiten $t_1$ und $t_5$ mit der Grundlast (Stromzustands-Identifikator A(0)) wird durch die Batterie 2 eine Grundspannung $U_{L=0}(t_1)$ bzw. $U_{L=0}(t_5)$ gemessen, die typischerweise über fast die gesamte Lebensdauer der Batterie aufrecht erhalten werden kann, bis die Entladung der Batterie über 90 % oder 95 % liegt. Dies liegt an dem vergleichsweise niedrigen Dauerstrom I, mit dem die Batterie 2 in der Grundlast ständig belastet ist. Dieser Dauerstrom I wird durch verschiedene Strompulse von Verbrauchern 3 überlagert, wenn diese bestimmte arbeitsintensive Aufgaben erfüllen. Während dieser Strompulse mit den Lastzustands-Identifikatoren A(1), A(2) oder A(3) lässt sich in der Spannung $U_L$ der Batterie 2 ein gewisser Spannungseinbruch im Vergleich zu der Grundspannung $U_{L=0}$ erkennen, der von der Höhe und Dauer des Strompulses abhängt. Dieser Spannungseinbruch ist der Tatsache geschuldet, dass in der Batterie 2 nur eine endliche Menge an Energie bzw. Ladung zur Verfügung steht und bei einer hohen Beanspruchung der Batterie 2 die zur Verfügung gestellte Betriebsspannung $U_L$ zu einem gewissen Grad einbricht. Auch an dieser Stelle sei angemerkt, dass auch der dargestellte Verlauf der Betriebsspannung $U_L$ schematisch ist und in beliebigen Einheiten erfolgt, wobei aus der Darstellung auch kein Rückschluss auf das relative Verhalten der Betriebsspannung $U_L$ im Fall der verschiedenen Strompulse gezogen werden kann.

Sobald der Verbraucher 3 abgeschaltet wird, d.h. der Strompuls beendet ist und der Stromwert I wieder auf den Grundstrom zurückfällt, erholt sich die Betriebsspannung $U_L$ der Batterie 2 und kehrt auf den Ausgangswert der Betriebsspannung in der Grundlast zurück, die der Ruhespannung des entsprechenden Batterie-Entladegrades entspricht.

Da Verbrauchserfassungsgeräte 1 während der Lebenszeit der Batterie 2, die üblicherweise zehn und mehr Jahre betragen soll, wiederholt immer wieder dieselben Tätigkeiten ausführen, treten verschiedene Lastzustände über die Zeit wiederholt auf. Dies ist in Fig. 2 dadurch dargestellt, dass sich die Lastzustände A(0) bis A(3) in identischer Weise wiederholen. Die Erfindung ist jedoch nicht auf diesen Fall der identischen Wiederholung beschränkt, sondern schließt auch andere Anwendungsfälle an, in denen die verschiedenen Lastfälle A auch mit ggf. jeweils unterschiedlicher, über die Zeit wechselnder Frequenz auftreten können.

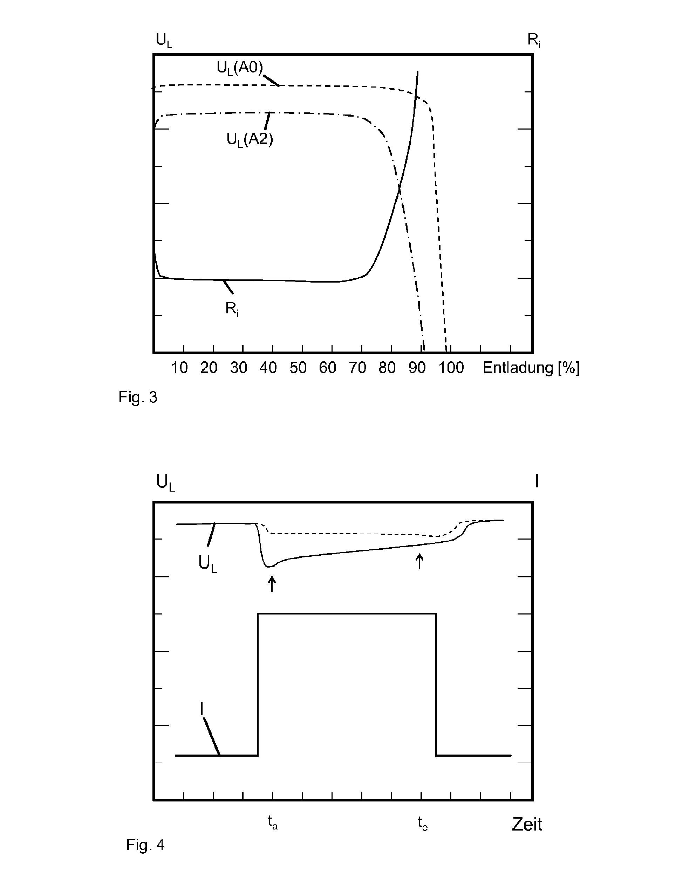

Der in Fig. 2 für einen kurzen Ausschnitt aus der Lebensdauer der Batterie 2 dargestellte Spannungsverlauf ist in Fig. 3 noch einmal für die gesamte Lebensdauer der Batterie 2 bis zu ihrer vollständigen Entladung von 100 % dargestellt, wobei die Betriebsspannung $U_L$ in der gestrichelten Linie für die Belastung der Batterie mit dem Grundstrom (Lastzustands-Identifikator A(0)) und der strichpunktierten Linie für die Belastung mit dem größten, stärksten Strompuls (Lastzustands-Identifikator A(2) gemäß Fig. 2) dargestellt ist.

Im Falle der Grundlast A(0) wird die Betriebsspannung $U_{L=0}$ bis etwa 90 % bis 95 % der Entladung gehalten. Bei einer weiteren Entladung fällt die Betriebsspannung $U_L$ schnell ab. Die Batterie muss getauscht werden. Wie auch Fig. 2 zu entnehmen, ist die Betriebsspannung $U_L$ im Fall einer höheren Belastung durch Strompulse mit im Vergleich zur Grundlast hoher Amplitude niedriger. Auch in diesem Fall kann die Betriebsspannung über einen weiten Bereich der Entladung bis hin zu etwa 50 bis 70 % der Entladung konstant gehalten werden. Bei einer höheren Entladung beginnt die während der Strompulse gemäß Lastzustand A(2) zur Verfügung gestellte Betriebsspannung $U_{L=2}$ zu sinken, um bei weiterer Entladung schnell abzufallen. Bei einer etwa 90 %-igen Entladung der Batterie 2 kann die Betriebsspannung $U_L$ im Falle der höheren Beanspruchung der Batterie im Lastfall A(2) nicht mehr zur Verfügung gestellt werden.

In demselben Diagramm der Fig. 3 ist auch der Verlauf des Innenwiderstands $R_i$ dargestellt. Es zeigt sich, dass der Innenwiderstand $R_i$ der Batterie 2 über einen weiten Zeitraum der Entladung der Batterie 2 konstant ist und zu steigen beginnt, wenn die Entladung soweit fortgeschritten ist, dass in Kürze die Spannung für den Lastfall A(2) nicht mehr aufrecht erhalten werden kann. Sobald die Spannung im Lastfall A(2) zu fallen beginnt, steigt auch der Innenwiderstand $R_i$ rapide an.

Vor diesem Hintergrund ist ersichtlich, dass es nicht ausreichend ist, die Spannung $U_{L=0}$ der Batterie 2 bei der Grundlast (d.h. im Lastfall A(0)) zu messen, sondern dass die Spannung $U_L$ für die verschiedenen Lastfälle A gesondert überwacht werden muss. Da je nach Lastfall A der Verlauf der Entladekurve sehr unterschiedlich sein kann, ist es sinnvoll in einem Zeitintervall möglichst viele oder alle der typischerweise auftretenden Lastfälle A des Verbrauchserfassungsgeräts abzudecken und zu überwachen, ob bei einem dieser Lastfälle die Spannung unter einen vorgegebenen Schwellwert sinkt, der vorzugsweise so zu bemessen ist, dass dieser Schwellwert noch einen gewissen Sicherheitsabstand zu dem minimalen Spannungswert aufweist, der für die Grundversorgung des Verbrauchserfassungsgeräts notwendig ist.

Wenn dagegen der Verlauf der Ruhespannung $U_{L=0}$ und der Verlauf des Innenwiderstands $R_i$ überwacht wird, kann in Kenntnis eines jeweils auftretenden Laststromes in dem Lastfall Ax eine Aussage zu der sich einstellenden Lastspannung $U_L$ (Ax, t) getroffen werden. Es kann also vorhergesagt werden, bei welchem Laststrom bzw. Lastfall die minimal zur Verfügung zustellende Gerätespannung unterschritten würde. Die Ruhespannung $U_{L=0}$ der Batterie ist jedoch exemplarabhängig und verändert sich außerdem mit der Umgebungstemperatur. In einem in Fig. 2 dargestellten Zeitintervall bzw. Zeitraum von bspw. einem Tag kann aber das Minimum bzw. der Minimalwert der gemessenen Spannung $U_L$ bestimmt und hieraus ein Rückschluss gezogen werden, wie weit die Entladung der Batterie 2 fortgeschritten ist.

Der qualitativen Darstellung der Fig. 3 ist auch zu entnehmen, dass die Spannung $U_L$ im Lastfall A(0) auch zu Beginn der Entladung im Wesentlichen konstant ist. Im Lastfall A(2) ist die Betriebsspannung $U_L$ der Batterie 2 dagegen so, dass die Betriebsspannung $U_L$ zunächst niedriger ist und dann zu dem Plateauwert hin ansteigt. Entsprechend lässt sich bei dem Innenwiderstand $R_i$ ein Abfall des Innenwiderstands $R_i$ zu Beginn der Entladung der Batterie 2 feststellen, bis das Plateau des Innenwiderstands $R_i$ über die weitaus größte Lebenszeit der Batterie 2 erreicht wird.

Der Grund hierfür ist die sog. Passivierung der Batterie 2, bei der die Anode der Batterie während des Nichtgebrauchs, d.h. bei der Lagerung der Batterie zwischen der Herstellung und dem Einsatz der Batterie, mit einer Deck- bzw. Passivierungsschicht überzogen wird, welche dazu führt, dass zunächst nicht die volle Energie der Batterie zur Verfügung gestellt werden kann. Diese Passivierungsschicht wird im Gebrauchsfall, wenn ein hinreichend großer Strom über eine hinreichend lange Zeit geflossen ist, wieder aufgebrochen, so dass dieser Effekt der Passivierung typischerweise bei dem Ersteinsatz der Batterie auftritt und durch den Gebrauch zurückgeführt wird.

Allerdings kommt es bei vielen Batterietypen auch dann zu einer Passivierung, wenn der mittlere Strom über einen bestimmten Zeitraum während des Betriebs der Batterie einen vorgegebenen Wert nicht übersteigt, wobei der Strom auf die Größe der Elektrodenfläche normiert ist. Typische Werte hier liegen bei 2 $\mu A/cm^2$. Für die Bestimmung des Batterieladezustands durch Spannungsmessung ist es daher wichtig, dass die Messung in einem Zustand der Batterie stattfindet, in welcher keine Passivierung vorliegt. Daher ist erfindungsgemäß vorgesehen, den Passivierungszustand der Batterie 2 vorzugsweise in vorgebbaren Abständen zu überprüfen. Dazu wird zu einem Zeitpunkt geringer Aktivität des Verbrauchserfassungsgeräts 1, d.h. wenn längere Zeit sehr wenig oder kein Strom I aus der Batterie 2 entnommen wurde, die Batterie 2 mit einem kurzen Strompuls entladen, wie er in Fig. 4 dargestellt ist. Gleichzeitig wird der Spannungsverlauf $U_L$ der Batterie 2 gemessen. Sofern, was in Fig. 1 nicht dargestellt ist, ein Pufferkondensator zwischen den Klemmen 6 der Batterie verwendet wird, muss der Strompuls solange anliegen, bis der Umladevorgang abgeschlossen ist.

Falls keine Passivierung vorliegt, zeigt die gemessene Spannung $U_L$ etwa den gestrichelten Verlauf. Man erkennt, dass die Spannung $U_L$ zu Beginn des Strompulses leicht absinkt und dann im Wesentlichen konstant bleibt bzw. leicht weiter abfällt, um nach Beendigung des Strompulses wieder auf den Ausgangswert anzusteigen.

Im Falle einer Passivierung, die durch die durchgezogene Linie dargestellt ist, steht zu Beginn des Strompulses aufgrund der Passivierungsschicht weniger Energie zur Verfügung, was sich an einem stärkeren Abfall der Betriebsspannung $U_L$ der Batterie 2 zeigt. Diese steigt trotz der Belastung während des Strompulses weiter an, da durch den fließenden Strom die Passivierungsschicht aufgebrochen wird. Nach Beendigung des Strompulses steigt die Betriebsspannung $U_L$ in jedem Fall wieder auf die Ausgangsspannung an.

Indem nun die Betriebsspannung $U_L$ zu einem Zeitpunkt $t_a$ kurz nach Beginn des Strompulses und zu einem Zeitpunkt $t_e$ kurz vor Ende des Strompulses gemessen wird, kann die Passivierung der Batterie ermittelt werden, wobei die Betriebsspannung bei Grundlast $U_L(A(0))$ bekannt ist oder kurz vor Erzeugen des Strompulses gemessen wird. Der Innenwiderstand $R_i$ lässt sich dann gemäß der folgenden Gleichungen für den Messzeitpunkt $t_a$ und dem Messzeitpunkt $t_e$ ableiten.

Aus der allgemeinen Bestimmung der Betriebsspannung $U_L$ gemäß

$$U_L = U_o - R_i \cdot I .$$

folgt

$$R_i(t_{a/e}) = \frac{U_L(A(0)) - U_L(t_{a/e})}{I(t_{a/e}) - I(A(0))} \approx \frac{U_L(A(0)) - U_L(t_{a/e})}{I(t_{a/e})} ,$$

wobei die Näherung für den Fall gilt, dass der Strom $I(A(0))$ im Falle der Grundlast $A(0)$ viel kleiner ist als im Falle des Strompulses $I(A(t_a/t_e))$.

Wenn der Innenwiderstand $R_i(t_a)$ größer ist als der Innenwiderstand $R_i(t_e)$ kann davon ausgegangen werden, dass eine Passivierung vorliegt. Sofern die Innenwiderstände $R_i$ dagegen gleich sind, ist anzunehmen, dass keine Passivierung der Batterie 2 vorliegt. Sofern eine Passivierung vorliegt, kann diese durch erneute Anwendung eines vergleichbaren Strompulses über längere Zeit vollständig aufgebrochen und damit rückgeführt werden.

Zur Ermittlung des Ladezustands der Batterie 2 wird, nachdem die Batterie 2 wie vorbeschrieben ggf. in einen depassivierten Zustand versetzt wurde, die Batteriespannung $U_L$ in Lastzuständen großer Belastung kurz vor dem Ende dieser Belastung gemessen, d.h. bspw. kurz vor Beendigung des Sendevorgangs eines Funktelegramms in maximaler Sendeleistung, kurz vor Beendigung von lange andauernden Aktivitätsphasen des Mikroprozessors oder dgl.. In einem vorgegebenen Zeitintervall, in dem vorzugsweise alle die zu berücksichtigenden Lastzustände des Verbrauchserfassungsgeräts 1 mindestens einmal aufgetreten sind bzw. üblicherweise einmal auftreten, wird das Minimum der aufgetretenen Spannungen $U_L$ bestimmt.

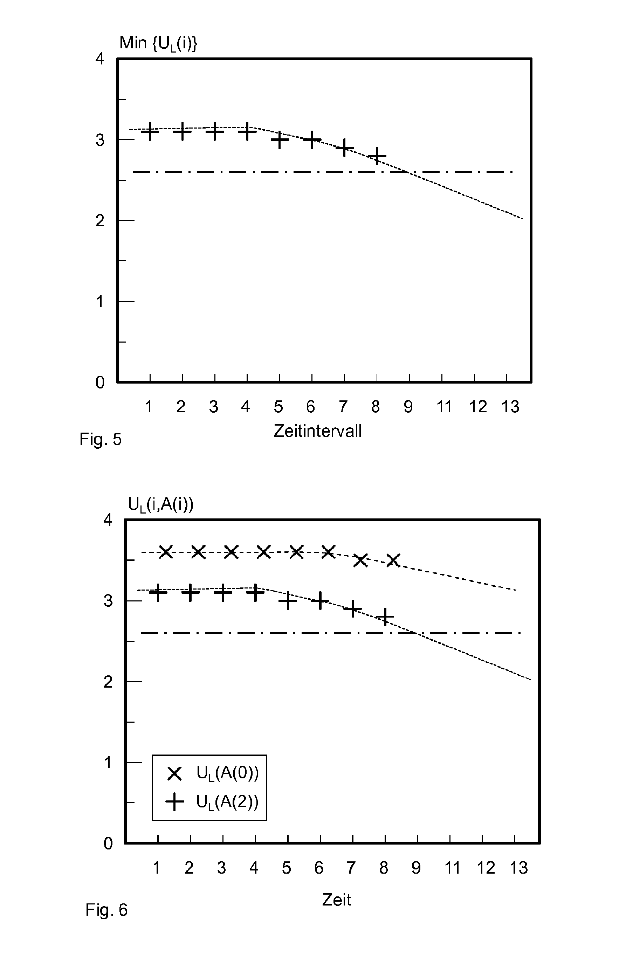

In Fig. 2 sind vor diesem Hintergrund bspw. zwei Zeitintervalle $t_1$ bis $t_4$ und $t_5$ bis $t_8$ dargestellt. In einer einfachsten Ausführungsform wird der in dem Zeitintervall aktuell ermittelte Minimalwert der Spannung $U_L$ mit einem in Fig. 6 strichpunktiert eingezeichneten Schwellwert für die Betriebsspannung $U_L$ verglichen. Sofern der Minimalwert der Spannung $U_L$ diesen Schwellwert unterschreitet, wird eine geeignete Aktion in dem Verbrauchserfassungsgerät durchgeführt, bspw. der Funktionsumfang reduziert und/oder das Gerät abgeschaltet. Erfindungsgemäß können statt des einen Schwellwertes auch gestaffelt mehrere Schwellwerte vorgesehen sein.

Besonders bevorzugt werden diese Minimalwerte für jedes Zeitintervall gespeichert und bspw. durch Anpassung einer geeignet parametrierten Funktion ein Trend für den Minimalwert der Spannung $U_L$ ermittelt, der eine Interpolation der gemessenen Werte darstellt und daher eine Extrapolation in die Zukunft erlaubt. Auf diese Weise ist eine Vorhersage möglich, wann die Extrapolation den vorgegebenen Schwellwert unterschreiten wird. Hierdurch können geeignete Maßnahmen, wie bspw. das Auslösen eines Batteriewechsels oder die stufenweise Einschränkung der Funktionalität des Verbrauchsmessgerätes 1, so rechtzeitig durchgeführt werden, dass in der Praxis ein Ausfall des Verbrauchserfassungsgeräts nicht zu befürchten steht. In Fig. 5 sind die Minimalwerte der Betriebsspannung $U_L$ als Kreuze und der ermittelte Trend als gestrichelte Kurve dargestellt.

Entsprechend wie bei Fig. 5 sehen die Auswertung und das Erkennen eines Trends auch für die Ausführungsform aus, in der ein ausgewählter charakteristischer Lastzustand A gemessen wird. Durch eine geeignete Auswahl des charakteristischen Lastzustands kann bereits der Lastzustand A ausgewählt werden, der jeweils den Anwendungsfall mit dem größten Energiebedarf und daher den Anwendungsfall mit der (erwarteten) minimalen gemessenen Spannung der Batterie 2 aufweist. In diesem Fall entspricht der gemessene Wert dem in Fig. 5 dargestellten Wert, sofern in dem Messzeitraum dieser charakteristische Lastfall nur einmal auftritt. Tritt dieser Lastfall innerhalb des Messzeitraums mehrfach auf, wird das Minimum dieser Messwerte gebildet.

Ebenso ist es möglich, einen bspw. häufig auftretenden, charakteristischen Lastfall zur Spannungsmessung auszuwählen. Für einen solchen Lastfall kann der Abstand der gemessenen Spannung zu der bei dem (von diesem charakteristischen Lastfall) verschiedenen Lastfall mit dem größten Energiebedarf auftretenden minimalen Spannung bekannt ist. Dieser Abstand kann bspw. eine auf Testmessungen beruhende Annahme sein. Dann wird von der gemessenen Spannung noch der Abstand abgezogen, um zu der Darstellung gemäß Fig. 5 zu gelangen, die dann in der beschriebenen Weise ausgewertet werden kann.

Eine alternative oder zusätzliche Auswertemöglichkeit sieht vor, die Spannungswerte $U_L$ für verschiedene Lastfälle A in Abhängigkeit der Messzeitpunkte separat für verschiedene Lastzustands-Identifikatoren A(0) bis A(3) bzw. Lastströme zu ermitteln. Der Übersichtlichkeit halber ist in Fig. 6 die Spannung $U_L$ nur für die Grundlast A(0) und die Maximallast A(2) dargestellt. Für jede der Messreihen wurde eine entsprechende Anpassung als gestrichelte Linie eingezeichnet. Hierdurch lässt sich bei im zeitlichen Mittel gleichbleibender Last an der Batterie 2 eine Vorhersage treffen, wann die Batterie 2 soweit entladen ist, dass der Schwellwert der Betriebsspannung $U_L$ nicht mehr erreicht wird und eine Aktion zur Aufrechterhaltung des Betriebs des Verbrauchserfassungsgeräts 1 notwendig ist.

Eine weitere Möglichkeit der Feststellung des Ladezustands der Batterie 2 besteht darin, aus einer Messung der Betriebsspannung $U_L$ in Kenntnis des in dem Lastfall aufgetretenen Stroms I entsprechend der vorstehend im Zusammenhang mit dem Innenwiderstand $R_i$ erläuterten Gleichung den Innenwiderstand $R_i$ zu ermitteln, wobei einfacherweise anstelle der Messzeitpunkte $t_{a/e}$ der obig genannten Gleichung der aktuelle Messzeitpunkt eingesetzt wird. Durch eine Auswertung des Verlaufs des Innenwiderstands $R_i$ kann nach einer Plateauphase (vgl. Fig. 3) dessen Ansteigen im Falle zunehmender Entladung ermittelt werden, typischerweise bevor es zu großen Spannungseinbrüchen in den Lastfällen kommt. Daher ist auch die Messung des Innenwiderstands $R_i$ und die Auswertung seines Verlaufs eine besonders geeignete, ggf. zusätzliche Maßnahme, um den Ladezustand der Batterie 2 zu ermitteln.

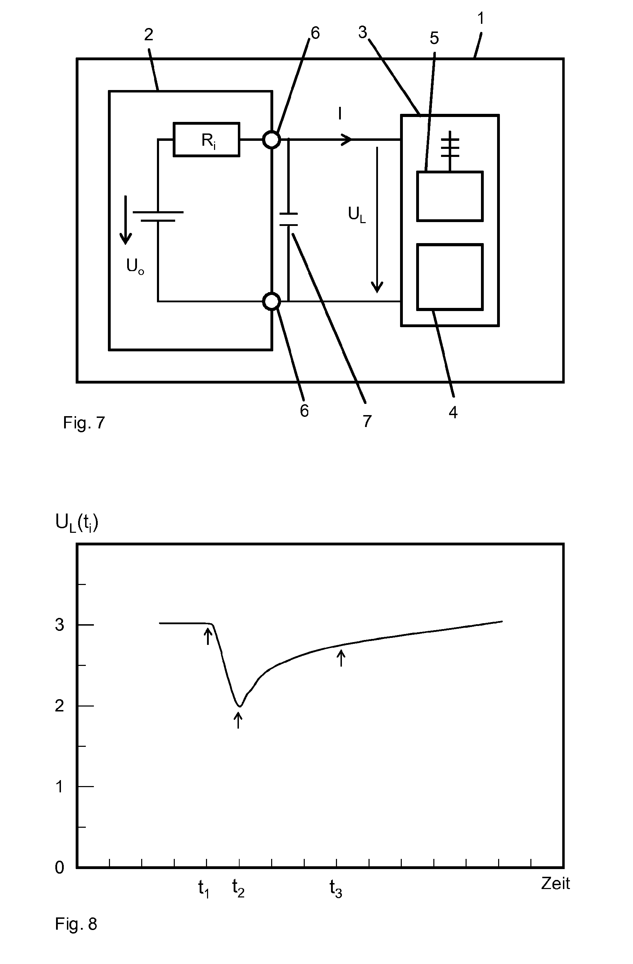

Da bei vielen batteriebetrieben Geräten 1 in der Verbrauchswerterfassung, bspw. einem Datensammler zum Empfangen bzw. Sammeln und/oder Weiterleiten von durch Verbrauchserfassungsgeräte mit Sensoren gemessenen Verbrauchswerten, hohe Lastspitzen auftreten, wie sie bspw. beim Senden von Daten über Funk entstehen, müssen solche Lastspitzen mit einem Pufferkondensator gestützt werden, damit die Batteriespannung nicht zu stark zusammenbricht. Ein solches Gerät 1 ist in Fig. 7 dargestellt.

Abgesehen von dem Pufferkondensator 7, der zwischen den Klemmen 6 in dem Gerät angeordnet ist, entspricht das Gerät 1 gemäß Fig. 7 dem Gerät 1 gemäß Fig. 1, so dass dieselben Bezugszeichen verwendet werden und die vorstehende Beschreibung einschließlich der verschiedenen Verfahrensvarianten zur Ermittlung des Batterieladezustands auch hierfür anwendbar ist.

Lediglich die Bestimmung des Innenwiderstands $R_i$ der Batterie 2 muss aufgrund des Pufferkondensators 7 anders erfolgen. Dies wird nachfolgend mit Bezug auf Fig. 8 erläutert.

Fig. 8 zeigt den Spannungsverlauf $U_L$ während eines Sendepulses bei einem Gerät 1 mit einem Pufferkondensator 7. Zur Bestimmung des Innenwiderstands $R_i$ der Batterie 2 mit Pufferkondensator 7 zwischen den Klemmen 6 werden drei Spannungsmesswerte $U_L(t_1) = U_1$, $U_L(t_2) = U_2$ und $U_L(t_3) = U_3$, zu verschieden Zeitpunkten des Spannungsverlaufs ermittelt. Der erste Zeitpunkt $t_1$, liegt vor, insbesondere kurz vor, dem Auftreten des Sendepulses. Als "kurz vor" sollen insbesondere Zeiten gelten, die höchstens 1 Sekunde, vorzugszugsweise sogar höchstens 50ms oder nur 10ms, vor dem Beginn des Sendepulses liegen. Maßgeblich ist, dass sie unmittelbar vor dem Auftreten des Lastfalls liegen, wobei unmittelbar derart zu verstehen ist, dass kein anderer von der Grundlast verschiedener Lastfall zwischen der Spannungsmessung zum Zeitpunkt $t_1$ und dem Beginn des zu vermessenden Lastfalls liegt. Der zweite Zeitpunkt $t_2$ markiert das Ende des Sendepulses, wobei die Messung der Spannung $U_L$ vorzugsweise noch innerhalb des Sendepulses beendet sein soll. Die Messung der Spannung $U_2$ wird also erfindungsgemäß unmittelbar vor dem Ende des Sendepulses initiiert, wobei die Zeitspanne zwischen dem Beginn der Messung und dem Ende des Sendepulses im Wesentlichen durch die Messzeit bestimmt ist und typischer Weise weniger als 10ms beträgt. Die letzte Messung zum Zeitpunkt $t_3$ erfolgt eine vorgegebene Zeit nach dem Auftreten des Sendepulses. Der Zeitpunkt $t_3$ liegt erfindungsgemäß während der Ladezeit des Pufferkondensators 7, abhängig vom erwarteten Wert des Innenwiderstands $R_i$, vorzugsweise mindestens etwa 20% vor Erreichen der Sättigungsspannung bezogen auf die Differenz zwischen Sättigungsspannung und der Spannung $U_2$. Einfacher Weise kann der Zeitpunkt $t_3$ eine vorgegebene Zeit nach dem Ende des Sendepulses, d.h. nach dem Zeitpunkt $t_2$, liegen. Eine in vielen Fällen sinnvolle Zeit liegt in der Größenordnung von 1s. Die einzustellende Zeit hängt insbesondere von dem erwarteten Innenwiderstand $R_i$ der Batterie 2 und der Kondensatorgröße, d.h. insbesondere dessen Kapazität, ab.

Sendepuls im Sinne der vorstehenden Beschreibung ist als durch einen Verbraucher abgerufener Strompuls zu verstehen, bei dem der Pufferkondensator 7 zumindest teilweise, vorzugsweise (maximal) zu etwa 18%, entladen wird. Dies ist üblicher Weise bei einem Sendevorgang eines Verbrauchserfassungsgeräts bzw. Datensammlers der Fall, kann aber erfindungsgemäß auch durch andere Verbraucher hervorgerufen werden, ohne dass es sich hierbei um einen Sendepuls handeln muss. Die Beschreibung dieses Beispiels gilt also neben Sendepulsen für alle Lastfälle, welche auf die in dem Pufferkondensator gespeicherte Ladung zugreifen, um einen zu starken Spannungseinbruch der Batterie zu vermeiden.

Mit Hilfe dieser drei Spannungsmesswerte $U_1$, $U_2$ und $U_3$ sowie der zugehörigen Messzeitpunkte $t_1$, $t_2$ und $t_3$ werden die Zeitkonstante $\tau$ der Ladefunktion des Pufferkondensators 7 und mit Kenntnis der verwendeten Pufferkapazität C der Innenwiderstand $R_i$ der Batterie bestimmt.

Die nach Ende des Sendepulses einsetzende Ladung des Pufferkondensators 7 führt zu einer durch die Beziehung

$$U_L = (U_1 - U_2) \cdot (1 - e^{-t/\tau})$$

gegebenen Spannung $U_L$. Zum Zeitpunkt $t_3$ ergibt sich somit die Zeitkonstante $\tau$ als

$$\tau = \frac{t_3 - t_2}{-\ln\left(1 - \left(\frac{U_3}{U_1 - U_2}\right)\right)}.$$

Andererseits ist die Zeitkontstante $\tau$ definiert als $\tau = R \cdot C$, wobei die Pufferkapazität C als das Verhältnis der Ladung Q zu der Spannung U gegeben ist. Somit gilt:

$$\tau = R \cdot \frac{Q}{U} = R \cdot \frac{I \cdot (t_2 - t_1)}{U_1 - U_2},$$

da die Ladung dem in der Zeit $t_2$ - $t_1$ geflossenen Strom entspricht. Dieser Strom des Verbrauchers ist für einen typischen Sendevorgang bzw. eine typische Funktion des Verbrauchers bekannt. Hieraus lässt sich der Innenwiderstand $R_i$ der Batterie 2 berechnen.

Die weitere Auswertung erfolgt entsprechend der vorstehenden Beschreibung. Somit kann mit der Erfassung dieser vorbeschriebenen Messwerte $U_1$, $U_2$, $U_3$ und $t_1$, $t_2$, $t_3$ bei bekanntem Verbraucherstrom I auf den über die Entladung der Batterie 2 ansteigenden Innenwiderstand $R_i$ geschlossen und der tatsächliche Entladegrad der Batterie 2 abgeleitet werden. Kritische Entladezustände können direkt über die Spannung $U_2$ erkannt werden, die für diesen Sendevorgang bzw. Lastfall den minimalen Spannungswert liefert.

In einer konkreten Geräteimplementierung kann der Ablauf wie folgt stattfinden: Bei jedem Sendevorgang und/oder anderen, vorzugsweise ausgesuchten, typischen Lastfällen werden mit der vorhandenen (und in der Fertigung abgeglichenen) Batteriemessschaltung des Geräts 1, insbesondere eines Datensammlers, die Batteriespannung $U_1$ vor dem Sendevorgang zum Zeitpunkt $t_1$, die Batteriespannung $U_2$ unmittelbar vor dem Ende des Sendevorgangs zum Zeitpunkt $t_2$ und die Batteriespannung $U_3$ nach dem Sendevorgang zum Zeitpunkt $t_3$ gemessen. Der Zeitpunkt $t_3$ liegt vorzugsweise etwa 1 s nach dem Zeitpunkt $t_2$. Die Zeit $t_2$ kann als Differenz $dt_2 = t_2 - t_1$ relativ zur Messzeit $t_1$ bspw. in 1/100 ms erfasst werden und als 1-Byte-Wert abgespeichert werden. In ähnlicher Weise ist es möglich, die Zeit $t_3$ als Differenz $dt_3 = t_3 - t_2$ relativ zur Messzeit $t_2$ zu erfassen und als 1-Byte-Wert abzuspeichern. Dies führt zu komprimierten Datensätzen, was insbesondere bei einer Funkübertragung der Datensätze zu einer Auswertezentrale sinnvoll ist, um Übertragungskapazität und Batterieleistung zu sparen.

Ebenso wird die Temperatur als Mikroprozessor-Temperatur "Temp" zu mindestens einem dieser Zeitpunkt $t_1$, $t_2$, $t_3$ gemessen, vorzugsweise zum Zeitpunkt $t_2$ bei der größten Last gegen Ende des Lastfalls.

Das Speichern des Datensatzes erfolgt, wie bspw. auch bei den anderen Verfahren möglich, getriggert von der niedrigsten Spannung $U_L$, die innerhalb eines Zeitintervalls (Erfassungszeitraum von bspw. 1 Tag) gesehen wird. Der Spannungshub und damit die Auflösung sind am größten, wenn bei Auftreten der geringsten Spannung $U_L$ der Innenwiderstand $R_i$ bestimmt wird. Unterschreitet also der Spannungswert $U_2$ der aktuellen Messung den niedrigsten Spannungswert $U_2$ des laufenden Zeitintervalls, so wird der komplette Datensatz mit den Messwerten $U_1$, $U_2$, $t_2$, $U_3$, Temp durch den aktuellen Messwertsatz ersetzt. Der aktuelle Messwertsatz (Tageswerte) wird über einen Tag lang (z.B. von 00:01 Uhr bis 00:00 Uhr) aktualisiert und am Tagesende zum Abholen durch einen übergeordneten Masterdatensammler zwischengespeichert. Somit werden insgesamt 10 Variablen (10 Bytes) benötigt: $U_{1\_akt}$, $U_{2\_akt}$, $U_{3\_akt}$,

$t_{2\_akt}$, $Temp_{akt}$ des aktuellen Zeitintervalls (1 Tag) und $U_{1\_d}$, $U_{2\_d}$, $U_{3\_d}$, $t_{2\_d}$, $Temp_d$ des letzten Tages. Die "Tageswerte" stehen jeweils am Tagesende bis zum nächsten Tag zur Abholung durch den Masterdatensammler bereit. Werden die Daten nicht abgeholt, werden sie überschrieben.

In diesem Beispiel werden die Rohwerte übertragen. Es ist jedoch auch möglich die Berechnung, des Innenwiderstandes Ri und der daraus gebildeten Funktion im Gerät 1 durchzuführen und nur den tatsächlichen Batteriestatus (Restkapazität) zu übertragen. Die Übertragung der Rohwerte hat aber den Vorteil, dass der zugrunde gelegte Algorithmus extern geprüft und weiterentwickelt werden kann. Außerdem kann die Korrelation mit einem Verfahren, bei dem nur die Mindestspannungen $U_2$ aufgezeichnet und extrapoliert werden, geprüft werden.

Aus der abfallenden Flanke (Zeitpunkt: $t_1..t_2$) während einer bekannten Last (Sendepuls) kann bei bekanntem Laststrom auf die Kapazität, bzw. im umgekehrten Fall, falls die Kapazität bekannt ist, auf den Laststrom geschlossen werden. Dieser kann zur Selektion der Stromverbrauchsanteile herangezogen werden ($A_0$, $A_1$, A2 in Fig. 2) und ermöglicht die Betrachtung des Innenwiderstands $R_i$ unter verschiedenen Lastfällen.

Mit dem erfindungsgemäßen Verfahren kann bspw. zunächst bei bekannten Sendestrom die Kapazität bestimmt und im Folgenden aus der dann bekannten Kapazität die unterschiedlichen Lastströme errechnet werden. Außerdem lässt sich die Änderung (Alterung) der Kapazität über die Lebensdauer des Gerätes verfolgen.

**Bezugszeichenliste:**

| | |
|---|---|
| 1 | batteriebetriebenes Gerät, Verbrauchserfassungsgerät, Datensammler |
| 2 | Batterie |
| 3 | Verbraucher |
| 4 | Mikroprozessor |
| 5 | Sende- und Empfangseinrichtung |
| 6 | Klemme |
| 7 | Pufferkondensator |

$U_L$   Spannung der Batterie, Betriebsspannung, Lastspannung oder Ruhespannung
I   Strom
$U_o$   Zellspannung
$R_i$   Innenwiderstand
A   Lastzustands-Identifikator

**Patentansprüche**

1. Verfahren zur Ermittlung des Batterieladezustands einer Batterie (2) in einem batteriebetriebenen Gerät (1) mit zeitlich wechselndem Stromverbrauch, bei dem die Spannung ($U_L$) der Batterie (2) gemessen und daraus ein Kriterium für den Batterieladezustand abgeleitet wird, **dadurch gekennzeichnet, dass** die Spannung ($U_L$) der Batterie (2) in mindestens zwei verschiedenen Lastzuständen (A) oder einem ausgewählten charakteristischen Lastzustand (A) gemessen wird.

2. Verfahren nach Anspruch 1, **dadurch gekennzeichnet, dass** der Minimalwert der gemessenen Spannungen ($U_L$) ermittelt und mit einem Schwellwert verglichen wird.

3. Verfahren nach Anspruch 1 oder 2, **dadurch gekennzeichnet, dass** die bei einer gemessenen Spannung ($U_L$) herrschende Temperatur erfasst wird.

4. Verfahren nach einem der vorhergehenden Ansprüche, **dadurch gekennzeichnet, dass** der Wert der gemessenen Spannung ($U_L$), der Anlass des Lastzustands (A) und/oder der Zeitpunkt der Messung (t) sowie ggf. die bei der gemessenen Spannung ($U_L$) herrschenden Temperatur und/oder ggf. anlagenspezifischer Daten in einem Datensatz gespeichert werden.

5. Verfahren nach einem der vorhergehenden Ansprüche, **dadurch gekennzeichnet, dass** aus je mindestens zwei Werten der gemessenen Spannung ($U_L$) mit unterschiedlicher Last der Innenwiderstand ($R_i$) der Batterie (2) ermittelt und der Verlauf des Innenwiderstands ($R_i$) über die Zeit ausgewertet wird.

6. Verfahren nach einem der vorhergehenden Ansprüche, **dadurch gekennzeichnet, dass** in einem batteriebetriebenen Gerät (1) mit einem Pufferkondensator (7) der Spannungsverlauf in einem Lastfall (A) durch drei Messungen der Spannung ($U_L$) der Batterie (2) zu drei verschiedenen Zeitpunkten ($t_1$, $t_2$, $t_3$) gemessen wird, wobei eine erste Messung zum Zeitpunkt $t_1$ vor Beginn des Lastfalls (A), die zweite Messung zum Zeitpunkt $t_2$ vor Ende des Lastfalls (A) und die dritte Messung zum Zeitpunkt $t_3$ eine vordefinierte Zeit nach Ende des Lastfalls (A) erfolgt.

7. Verfahren nach einem der vorhergehenden Ansprüche, **dadurch gekennzeichnet, dass** eine Überprüfung der Passivierung der Batterie (2) durch Messen der Spannung ($U_L$) der Batterie (2) in einem Strompuls erfolgt, wobei ein erster Passivierungs-Spannungswert ($U_L(t_a)$) unmittelbar nach dem Beginn des Strompulses und ein zweiter Passivierungs-Spannungswert ($U_L(t_e)$) unmittelbar vor dem Ende des Strompulses gemessen und aus jeder Messung der Innenwiderstand ($R_i$) bestimmt wird.

8. Verfahren nach Anspruch 7, **dadurch gekennzeichnet, dass** bei einer festgestellten Passivierung durch Anschalten eines Verbrauchers (3) mit vorgewählter Stromstärke über einen vorgewählten Zeitraum die Passivierung der Batterie (2) rückgeführt wird.

9. Verfahren nach einem der vorhergehenden Ansprüche, **dadurch gekennzeichnet, dass** als Messung in einem Lastzustand (A) ohne Last oder zusätzlich die Ruhespannung ($U_{L=0}$) der Batterie (2) gemessen wird.

10. Verfahren nach einem der vorhergehenden Ansprüche, **dadurch gekennzeichnet, dass** eine Vorhersage der Lebensdauer der Batterie (2) auf der Grundlage der gemessenen Spannungen ($U_L$) durchgeführt wird.

11. Verfahren nach Anspruch 10, **dadurch gekennzeichnet, dass** durch Interpolation der über die Zeit ermittelten Minimalwerte der Spannungen ($U_L$) ein Trend der Minimalwerte der Spannungen ($U_L$) der Batterie (2) abgeleitet und der erwartete Zeitpunkt festgestellt wird, wann der Minimalwert der Spannung ($U_L$) aufgrund des Trends einen vorgegebenen Schwellwert unterschreitet.

12. Verfahren nach Anspruch 10 oder 11, **dadurch gekennzeichnet, dass** die Spannung ($U_L$) der Batterie zu verschiedenen Zeitpunkten bei gleicher Last gemessen wird und ein Trend der Spannung ($U_L$) der Batterie (2) abgeleitet wird für den Fall, dass sich die zukünftig Last der Batterie (2) nicht ändert.

13. Verfahren nach Ansprüche 12, **dadurch gekennzeichnet, dass** aus jeder Messung der Spannung ($U_L$) der Batterie (2) die Ruhespannung ($U_{L=0}$) der Batterie (2) abgeleitet wird und ein Trend der Ruhespannung ($U_{L=0}$) der Batterie (2) abgeleitet wird.

14. Batteriebetriebes Verbrauchserfassungsgerät mit einem Mikroprozessor (4) und einem Funksender und/oder Funkempfänger (5) zur drahtlosen Datenübertragung von Erfassungswerten, wobei der Mikroprozessor (4) über Messeingänge zur Messung einer Spannung ($U_L$) der Batterie (2) verfügt, **dadurch gekennzeichnet, dass** der Mikroprozessor (4) zur Durchführung des Verfahrens nach einem der Ansprüche 1 bis 13 eingerichtet ist.

Fig. 1

Fig. 2

Fig. 3

Fig. 4

Fig. 5

Fig. 6

Fig. 7

Fig. 8

**IN DER BESCHREIBUNG AUFGEFÜHRTE DOKUMENTE**

**In der Beschreibung aufgeführte Patentdokumente**

- EP 1308738 B1
- US 6127806 A